# EUROPÄISCHE PATENTANMELDUNG

(11) **EP 2 521 431 A2**
(43) Veröffentlichungstag der Anmeldung: **07.11.2012**
(21) Anmeldenummer: 12158227.4
(22) Anmeldetag: 06.03.2012
(51) Int. Cl.: H05K 7/20

(54) **Flüssigkeitsgekühltes Leistungshalbleitermodul**

(30) Priorität: 05.05.2011 DE 102011100524
(71) Anmelder: SEMIKRON Elektronik GmbH & Co. KG, 90431 Nürnberg (DE)
(72) Erfinder: Beckedahl, Peter, 90522 Oberasbach (DE); Bogen, Ingo, 90425 Nürnberg (DE); Ehler, Ralf, 91459 Markt Erlbach (DE); Dr. Kobolla, Harald, 90556 Seukendorf (DE); Dr. Stockmeier, Thomas, 90471 Nürnberg (DE)

(57) **Zusammenfassung**

Es wird ein flüssigkeitsgekühltes Leistungshalbleitermodul (1) beschrieben. Das Leistungshalbleitermodul (1) weist ein elektrisch isolierendes Gehäuse (11) auf, in dem eine Kühleinrichtung (13) mit einem Kühlflüssigkeits-Einlass (131) und einem Kühlflüssigkeits-Auslass (133) für eine Kühlflüssigkeit sowie leistungselektronische Subsysteme (12) angeordnet sind, wobei die Kühleinrichtung (13) Kühlkammern (132) aufweist, in denen die leistungselektronischen Subsysteme (12) mit der Kühlflüssigkeit in thermischem Kontakt stehen.

## Beschreibung

Die Erfindung betrifft ein flüssigkeitsgekühltes Leistungshalbleitermodul.

Flüssigkeitsgekühlte Leistungshalbleitermodule sind bekannt, wobei die Flüssigkeitskühlung bei hohen Stromdichten zu einer verlässlichen Abführung der in den Halbleiterbauelementen auftretenden Verlustwärme führt.

In der DE 102 05 408 A1 ist ein Halbleitermodul beschrieben, das in einem Gehäuse angeordnet ist, welches an einer Seite durch einen flüssigkeitsgekühlten Kühlkörper abgeschlossen ist.

In der DE 60 2005 006 310 T2 ist ein Durchflussverteilungsmodul beschrieben, das zur Verteilung eines Durchflusses von Flüssigkeit über eine zu kühlende Oberfläche vorgesehen ist. Weiter ist vorgesehen, dass mehrere solcher Module gestapelt werden. Das Durchflussverteilungsmodul weist einen Aufnahmeraum für ein zu kühlendes Halbleitersubstrat auf, wobei in dem Gehäuse des Durchflussverteilungsmoduls Löcher zur Aufnahme von elektrischen Anschlussklemmen vorgesehen sind. Es lassen sich so durch Aufeinanderstapeln von Durchflussverteilungsmoduln und Halbleitersubstraten flüssigkeitsgekühlte Halbleitermodule aufbauen.

Aufgabe der vorliegenden Erfindung ist es, ein verbessertes flüssigkeitsgekühltes Leistungshalbleitermodul mit einer leistungselektronischen Anordnung zu schaffen, das den einfachen Aufbau von leistungselektronischen Anordnungen aus Leistungshalbleitermoduln ermöglicht.

Erfindungsgemäß wird diese Aufgabe mit dem Gegenstand des Anspruchs 1 gelöst. Es wird ein flüssigkeitsgekühltes Leistungshalbleitermodul vorgeschlagen, wobei vorgesehen ist, dass das Leistungshalbleitermodul ein elektrisch isolierendes Gehäuse aufweist, in dem eine Kühleinrichtung mit einem Kühlflüssigkeits-Einlass und einem Kühlflüssigkeits-Auslass für eine Kühlflüssigkeit sowie leistungselektronische Subsysteme angeordnet sind, wobei die Kühleinrichtung Kühlkammern aufweist, in denen die leistungselektronischen Subsysteme mit der Kühlflüssigkeit in thermischem Kontakt stehen.

Durch die Anordnung von zu kühlenden leistungselektronischen Subsystemen und einer von einer Kühlflüssigkeit durchströmten Kühleinrichtung in einem Gehäuse wird ein besonders einfacher Aufbau erzielt, wobei die leistungselektronischen Subsysteme und die Kühleinrichtung durch das Gehäuse bei Transport, Einbau und im Betrieb optimal geschützt sind. Bei den leistungselektronischen Subsystemen kann es sich um Halbbrückenschaltungen handeln, die besonders in kaskadischer Anordnung für den Einsatz in Windkraftanlagen geeignet sind.

Es kann vorgesehen sein, dass die Kühleinrichtung aus einem elektrisch isolierenden Material ausgebildet ist. Die Kühleinrichtung kann beispielsweise als ein mittels Spritzguss gefertigter Kunststoffkörper aus einem thermoplastischen Kunststoff ausgebildet sein.

Es kann aber auch vorgesehen sein, dass die Kühleinrichtung aus Metall oder aus einer Metalllegierung ausgebildet ist. Die Kühleinrichtung kann beispielsweise aus einer Aluminiumlegierung ausgebildet sein.

Es kann vorgesehen sein, dass Steuerungsanschlüsse der leistungselektronischen Subsysteme als Kontaktfedern ausgebildet sind, die an Kontakten einer Steuerungsplatine unter Druck anliegen. Dadurch ergibt sich ein besonders montagefreundlicher Aufbau, wobei Löt- oder Schweißarbeiten zum Verbinden der Steuerungsanschlüsse untereinander und/oder mit einem Steuerungsmodul entfallen können.

Die Steuerungsplatine kann elektrische Leiterbahnen aufweisen, die die Kontakte der Steuerungsplatine mit Kontaktelementen von elektrischen Steckverbindern verbinden, die an einem Endabschnitt der Steuerungsplatine angeordnet sind.

Die elektrischen Steckverbinder der Steuerungsplatine können als Einbaustecker und/oder als Buchse ausgebildet sein. Wenn die Steuerungsanschlüsse auf mehr als einen Steckverbinder aufgeteilt sind, beispielsweise auf zwei Steckverbinder, so kann ein Verpolungsschutz erhalten werden, wenn der eine Steckverbinder als Einbaustecker und der andere Steckverbinder als Buchse ausgebildet ist.

Es kann vorgesehen sein, dass der Kühlflüssigkeits-Einlass und der Kühlflüssigkeits-Auslass sowie die elektrische Steckverbinder an einer Stirnfläche des Leistungshalbleitermoduls angeordnet sind. Es ergibt sich so ein besonders montagefreundlicher Aufbau, weil in einem Montageschritt sowohl die Verbindungen für die Kühlflüssigkeit als auch die elektrischen Verbindungen zur Übertragung der Steuerungssignale herstellbar sind.

Es kann weiter vorgesehen sein, dass in dem Gehäuse weiter Kondensatoren angeordnet sind, die mit internen Gleichspannungsanschlüssen elektrisch verbunden sind. Die Kondensatoren können als Schutz- und/oder Glättungskondensatoren vorgesehen sein.

Die Kondensatoren können vorteilhafterweise mit der Kühleinrichtung in thermischem Kontakt stehen. So können Kondensatoren mit einer kleineren Bauform vorgesehen sein und/oder die Lebensdauer der Kondensatoren kann wegen der Reduzierung der thermischen Belastung erhöht sein, so dass das Leistungshalbleitermodul eine erhöhte Zuverlässigkeit aufweist.

Es kann vorgesehen sein, dass eine interne Gleichspannungsverschienung die internen Gleichspannungsanschlüsse untereinander sowie mit den Kondensatoren und mit externen Gleichspannungsanschlüssen verbindet. Eine analoge Anordnung kann auch für die Wechselspannungsanschlüsse vorgesehen sein.

Es kann eine leistungselektronische Anordnung vorgesehen sein, umfassend mehrere vorstehend beschriebene Leistungshalbleitermodule und eine externe Kühleinrichtung, auf der die Leistungshalbleitermodule nebeneinander angeordnet sind und die einen ersten Durchtrittskanal und einen zweiten Durchtrittskanal für eine Kühlflüssigkeit aufweist, wobei die modulseitigen Kühlflüssigkeits-Einlässe mit dem ersten Durchtrittskanal und die modulseitigen Kühlflüssigkeits-Auslässe mit dem zweiten Durchtrittskanal oder umgekehrt flüssigkeitsdicht verbunden sind.

In einer bevorzugten Ausbildung sind die Leistungshalbleitermodule im Kühlmittelkreislauf parallel geschaltet. Es ist aber auch möglich, die Durchtrittskanäle so auszubilden, dass die Leistungshalbleitermodule im Kühlmittelkreislauf in Reihe geschaltet sind.

Die leistungselektronische Anordnung kann weiter ein Steuerungsmodul umfassen. Das Steuerungsmodul kann im einfachsten Fall externe Steuerleitungen auf die Leistungshalbleitermodule verteilen. Es kann auch vorgesehen sein, dass das Steuerungsmodul eine elektronische Steuerungsschaltung aufweist, die beispielsweise den Betrieb der Leistungshalbleitermodule steuert und überwacht.

Es kann vorgesehen sein, dass die externe Kühleinrichtung einen Leitungskanal aufweist, in dem eine Bus-Leiterplatte angeordnet ist, die Steckverbinder aufweist, die mit Steuerungs-Steckverbindern der Leistungshalbleitermodule und mit Steuerungs-Steckverbindern des Steuerungsmoduls verbindbar sind.

Die Leistungshalbleitermodule können nach dem Aufsetzen auf die externe Kühleinrichtung über die Steckverbinder steuerungsseitig untereinander und mit dem Steuerungsmodul verbunden sein.

Bei einer besonders vorteilhaften dreidimensionalen Ausgestaltung der Leistungshalbleitermodule mit im Wesentlichen quaderförmigem Aufbau sind an der Bodenseite des Leistungshalbleitermoduls die elektrischen Steckverbinder für die Steuerung des Leistungshalbleitermoduls sowie der modulseitige Kühlflüssigkeitseinlass und der modulseitige Kühlflüssigkeitsauslass angeordnet und an den beiden Stirnseiten einander gegenüberliegend Gleichspannungsanschlüsse und Wechselspannungsanschlüsse zur Einbindung des Leistungshalbleitermoduls in einen Leistungsstromkreis. Auf der Flüssigkeitskühleinrichtung sind die Leistungshalbleitermodule mit einander zugewandten Seitenflächen dicht an dicht angeordnet. Dadurch sind auch bei der so gebildeten leistungselektronischen Anordnung die Gleichspannungsanschlüsse auf der einen Seite und die Wechselspannungsanschlüsse auf der anderen Seite angeordnet, wodurch beispielsweise eine Kaskadierung der Leistungshalbleitermodule besonders einfach möglich ist. Bei diesem Aufbau ist als weiterer Vorteil erreicht, dass Hilfsanschlüsse, das heißt die Steuerungsanschlüsse, und Lastanschlüsse, das heißt die Gleichspannungsanschlüsse und die Wechselspannungsanschlüsse, an unterschiedlichen Seitenflächen des Leistungshalbleitermoduls angeordnet sind und so wirksam entkoppelt sind.

Die Erfindung wird nun anhand von Ausführungsbeispielen näher erläutert. Es zeigen
- Fig. 1: ein Ausführungsbeispiel eines erfindungsgemäßen Leistungshalbleitermoduls in perspektivischer Darstellung;
- Fig. 2: das Leistungshalbleitermodul in Fig. 1 mit aufgesetzter Steuerungsplatine;
- Fig. 3: eine aus den Leistungshalbleitermodulen in Fig. 1 aufgebaute leistungselektronische Anordnung;
- Fig. 4: ein zweites Ausführungsbeispiel des Leistungshalbleitermoduls in in perspektivischer Darstellung;
- Fig. 5a: das Leistungshalbleitermodul in Fig. 4 mit Blick auf die Gleichspannungsanschlüsse;
- Fig. 5b: das Leistungshalbleitermodul in Fig. 4 mit Blick auf die Wechselspannungsanschlüsse.

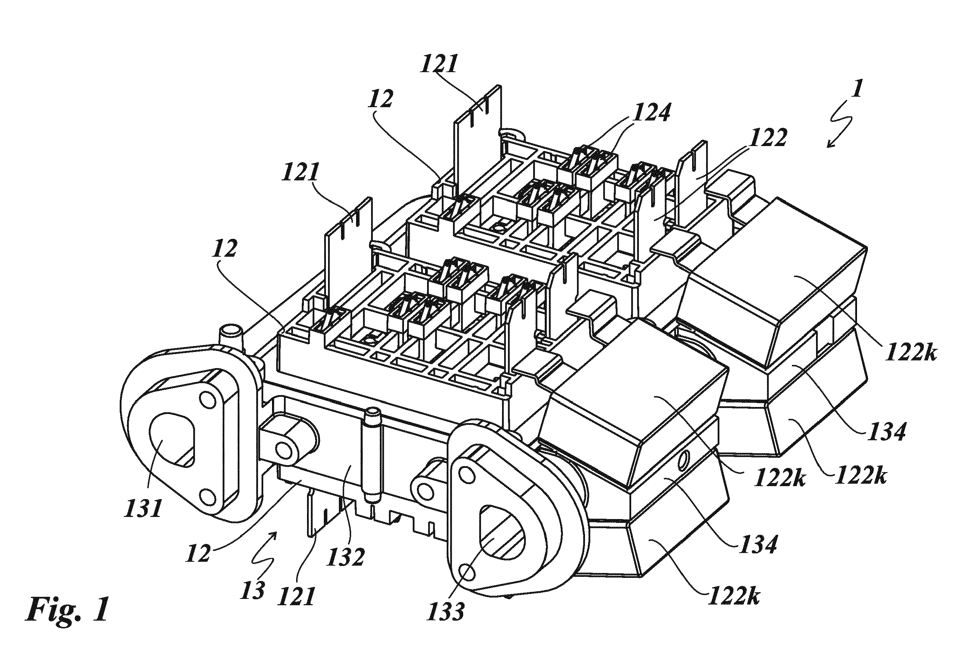

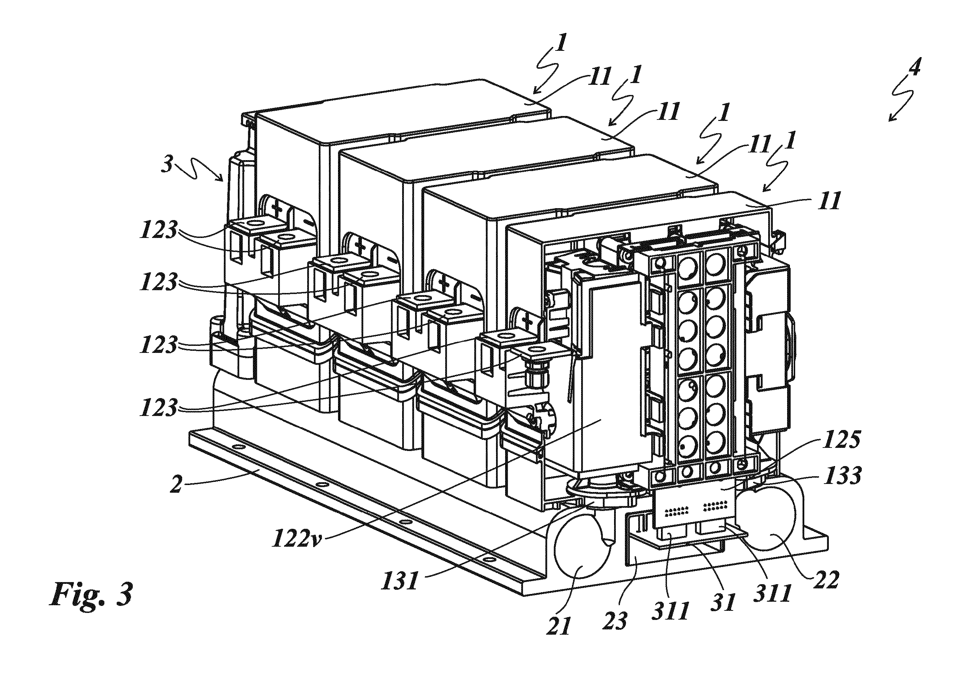

Fig. 1 zeigt ein teilweise aufgebautes Leistungshalbleitermodul 1, das in dem dargestellten Beispiel in einem Gehäuse 11 (siehe Fig. 3) vier leistungselektronische Subsysteme 12 aufweist, die auf einer gemeinsamen Kühleinrichtung 13 angeordnet sind. Die vier Subsysteme 12 sind zu je zwei Subsystemen einander gegenüberstehend in dem Gehäuse 11 angeordnet. Bei den leistungselektronischen Subsystemen 12 kann es sich um Halbbrückenschaltungen handeln, beispielsweise zum Einsatz in Windkraftanlagen.

Die Kühleinrichtung 13 ist aus einem elektrisch isolierenden Kunststoff gebildet. Die Kühleinrichtung 13 weist einen als Verteilungskanal ausgebildeten Eingangsabschnitt und einen als Sammlerkanal ausgebildeten Ausgangsabschnitt für die Kühlflüssigkeit auf. Der Eingangsabschnitt und der Ausgangsabschnitt sind parallel zueinander angeordnet. Zwischen den beiden Abschnitten sind vier trogförmige Kühlkammern 132 angeordnet, deren Trogöffnung jeweils von dem Substrat der zu kühlenden leistungselektronischen Subsystem 12 überdeckt ist. Zwischen der die Trogöffnung umgebenden Stirnfläche und der der Kühlkammer 132 zugewandten Substratoberfläche des leistungselektronischen Subsystems 12 ist ein ringförmiges Dichtelement angeordnet (in Fig. 1 nicht dargestellt), das beispielsweise in einer umlaufenden Nut in der Stirnfläche der zugeordneten Kühlkammer 132 angeordnet sein kann.

Die Kühlflüssigkeit tritt in einen modulseitigen Kühlflüssigkeits-Einlass 131 am Eingang des Eingangsabschnitts in die Kühleinrichtung 13 ein und fließt von dort in vier Kühlkammern 132, in denen sie in direkten Kontakt mit dem Substrat der Halbleiterbauelemente des leistungselektronischen Subsystems 11 gelangt. Bei dieser bevorzugten Ausbildung ist vorausgesetzt, dass die Kühlflüssigkeit elektrisch nicht leitend ist. Die aus den Kühlkammern 132 austretende erwärmte Kühlflüssigkeit wird im Ausgangsabschnitt der Kühleinrichtung 13 gesammelt und tritt an einem modulseitigen Kühlflüssigkeits-Auslass 133 aus.

Es kann vorgesehen sein, mehrere solcher Leistungshalbleitermodule 1 auf einer externen Kühleinrichtung 2 anzuordnen, wie weiter unten in Fig. 3 beschrieben.

Die leistungselektronischen Subsysteme 12 weisen einen Wechselspannungsanschluss 121, zwei interne Gleichspannungsanschlüsse 122 und einen externen Gleichspannungsanschluss 123 auf (siehe Fig. 3). Die internen Gleichspannungsanschlüsse 122 sind untereinander mittels einer internen Gleichspannungsverschienung 122v (siehe Fig. 3) sowie mit Kondensatoren 122k und mit den externen Gleichspannungsanschlüssen 123 verbunden.

Die Kondensatoren 122k sind paarweise auf Kühlblöcken 134 montiert, die mit der Kühleinrichtung 13 in thermischem Kontakt stehen oder Teil der Kühleinrichtung 13 sind.

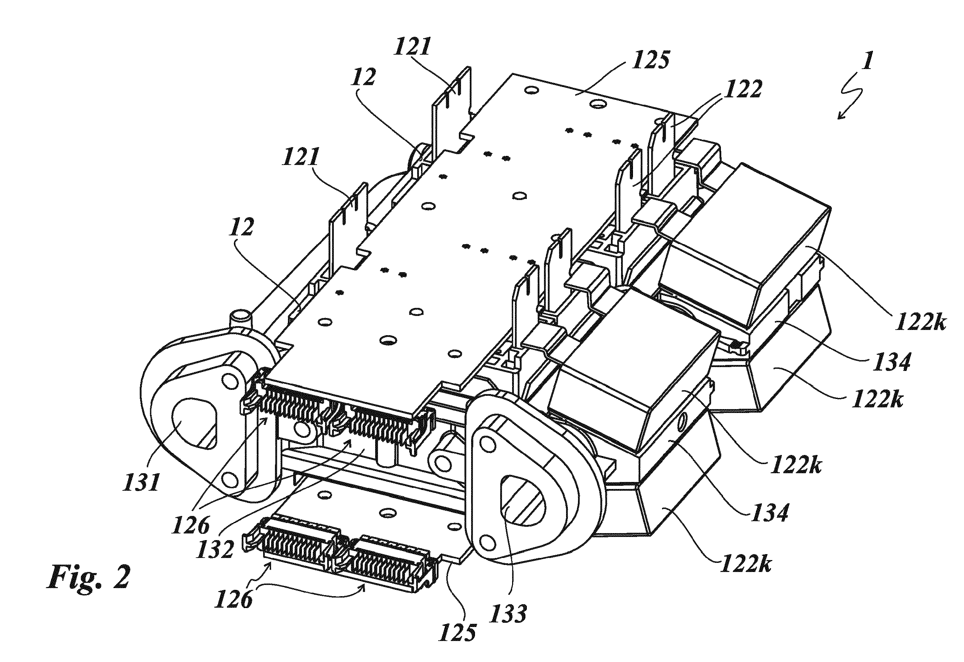

Die leistungselektronischen Subsysteme 12 weisen Steuerungsanschlüsse 124 auf, die als Kontaktfedern ausgebildet sind und an Kontakten einer über den Steuerungsanschlüssen 124 angeordneten Steuerungsplatine 125 (siehe Fig. 2) unter Druck anliegen. Die Steuerungsplatine 125 weist elektrische Leiterbahnen auf, die die Steuerungsanschlüsse 124 mit Kontaktfedern von Einbausteckern 126 verbinden, die an einer dem Kühlflüssigkeits-Einlass 131 bzw. dem Kühlflüssigkeits-Auslass 133 zugewandten Stirnseite der Steuerungsplatine 125 angeordnet sind. Entsprechend der Anzahl der Subsysteme 12 sind in dem Gehäuse 11 zwei Steuerungsplatinen 125 einander gegenüberliegend angeordnet, wie in Fig. 2 zu erkennen. Jede der beiden Steuerungsplatinen 125 ist mit Steuerungsanschlüssen 124 von zwei Subsystemen 12 verbunden.

Fig. 3 zeigt eine leistungselektronische Anordnung 4 aus mehreren Leistungshalbleitermodulen 1. In dem in Fig. 3 dargestellten Ausführungsbeispiel umfasst die leistungselektronische Anordnung 4 bis zu sechs flüssigkeitsgekühlte Leistungshalbleitermodule 1, die nebeneinander auf einer Montagefläche einer externen Kühleinrichtung 2 angeordnet sind, wobei in Fig. 3 vier Leistungshalbleitermodule 1 dargestellt sind.

Die externe Kühleinrichtung 2 ist also zugleich als eine Montageplattform für die Leistungshalbleitermodule 1 ausgebildet.

Die Kühleinrichtung 2 ist im Wesentlichen plattenförmig ausgebildet und von einem ersten Durchtrittskanal 21 und einem zweiten Durchtrittskanal 22 für die Kühlflüssigkeit durchgriffen. Die beiden Durchtrittskanäle 21 und 22 sind parallel zueinander angeordnet. Die Durchtrittskanäle 21, 22 weisen Ausleitungs- bzw. Einleitungsabschnitte auf, die in Kühlflüssigkeits-Auslässen bzw. in Kühlflüssigkeits-Einlässen an der Oberseite der externen Kühleinrichtung 2 münden und mit den Kühlflüssigkeits-Einlässen 131 (erster Durchtrittskanal 21) bzw. mit dem Kühlflüssigkeits-Auslässen 133 (zweiter Durchtrittskanal 22) des Leistungshalbleitermoduls 1 flüssigkeitsdicht verbunden sind. Auf diese Weise sind die nebeneinander auf der externen Kühleinrichtung 2 angeordneten Leistungshalbleitermodule 1 im Kühlkreislauf parallel geschaltet.

Die externe Kühleinrichtung 2 ist in einen nicht dargestellten Kühlkreislauf eingebunden, in dem die Kühlflüssigkeit umläuft, wobei der Kühlflüssigkeit die in den flüssigkeitsgekühlten Leistungshalbleitermodulen 1 aufgenommene Wärme entzogen wird. In den ersten Durchtrittskanal 21 strömt gekühlte Kühlflüssigkeit ein und aus dem zweiten Durchtrittskanal 22 strömt in den Leistungshalbleitermodulen 1 erwärmte Kühlflüssigkeit aus.

Zwischen den Stirnseiten des Kühlflüssigkeits-Einlasses 131 und des zugeordneten Kühlflüssigkeits-Auslasses des ersten Durchtrittkanals 21 sowie zwischen den Stirnseiten des Kühlflüssigkeits-Auslasses 133 und des zugeordneten Kühlflüssigkeits-Einlasses des zweiten Durchtrittskanals 22 kann ein Dichtungselement angeordnet sein. Es kann sich beispielsweise um ein Dichtungselement aus einem gummielastischen Material handeln. Im montierten Zustand des Leistungshalbleitermoduls 1 wird das Dichtungselement gegen die Oberseite der externen Kühleinrichtung 2 gepresst und bildet so eine Flüssigkeitsdichtung zwischen dem Leistungshalbleitermodul 1 und der externen Kühleinrichtung 2. Die korrespondierenden Kühlflüssigkeits-Einlässe und -Auslässe bilden zusammen mit den Dichtungselementen lösbare Kühlmittelverbindungseinrichtungen. Es kann aber auch vorgesehen sein, die Dichtungselemente als Kleberschichten auszubilden, woraus unlösbare oder bedingt lösbare Kühlmittelverbindungseinrichtungen resultieren.

Zur lösbaren Verbindung zwischen den Leistungshalbleitermodulen 1 und der externen Kühleinrichtung 2 können Befestigungsschrauben vorgesehen sein, die beispielsweise Durchgangslöcher der Kühleinrichtung 2 durchgreifen und in Gewindesacklöcher der Kühleinrichtung 13 eingreifen. Beim Anziehen der Befestigungsschrauben wird das Dichtungselement verpresst.

Auf der externen Kühleinrichtung 2 ist weiter ein Steuerungsmodul 3 angeordnet, das die Leistungshalbleitermodule 1 steuert. Zur elektrischen Verbindung mit den Leistungshalbleitermodulen 1 ist eine streifenförmige Bus-Leiterplatte 31 vorgesehen, die in einem die Kühleinrichtung 2 durchgreifenden Leitungskanal 23 angeordnet ist. Auf der Bus-Leiterplatte 31 sind Buchsen 311 angeordnet, deren Kontakte durch Leiterbahnen miteinander verbunden sind, wobei entsprechend dem gewählten Bus-System die Buchsen 311 parallel verbunden sind. Die Buchsen 311 nehmen die weiter oben beschriebenen Einbaustecker 126 der Leistungshalbleitermodule 1 auf, so dass die Steuerungsanschlüsse 124 der Leistungshalbleitermodule 1 auf das Bus-System geschaltet sind.

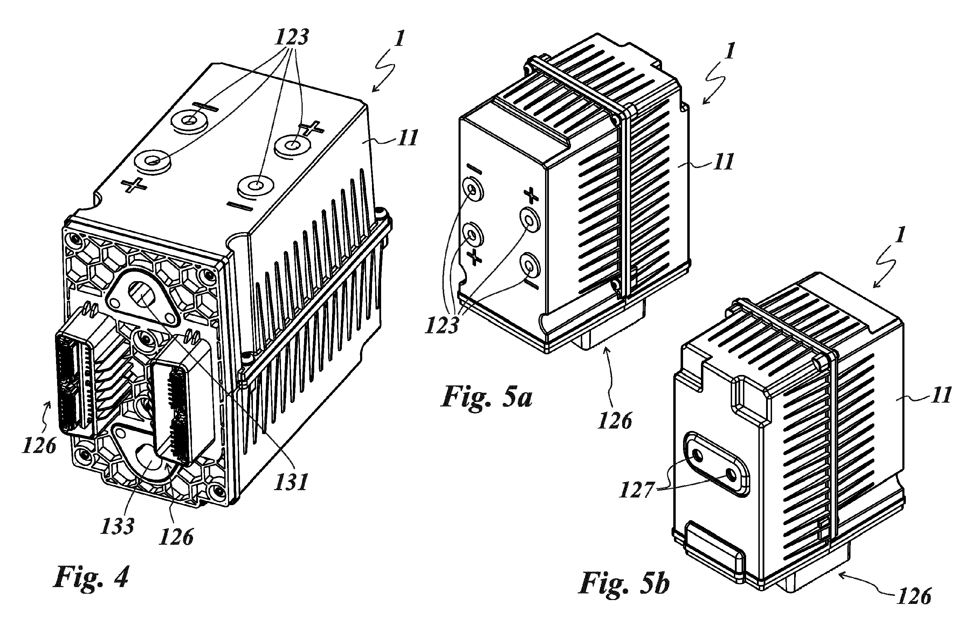

Die Fig. 4 sowie 5a und 5b zeigen ein zweites Ausführungsbeispiel eines Leistungshalbleitermoduls 1.

Wie in Fig. 4 zu erkennen, sind vier externe Gleichspannungsanschlüsse 123 vorgesehen, wobei vorzugsweise die Plus- und Minus-Anschlüsse doppelt ausgebildet und in zwei übereinander liegenden Reihen so angeordnet sind, dass bei zwei benachbarten Leistungshalbleitermodulen 1 die externen Gleichspannungsanschlüsse 123 auf kürzestem Weg zur Ausbildung einer Reihenschaltung miteinander verbunden werden können (siehe auch Fig. 5a).

Fig. 5b zeigt das Leistungshalbleitermodul 1 mit Blick auf externe Wechselspannungsanschlüsse 127.

Aus den Figuren 4, 5a und 5b wird der Vorteil der gewählten dreidimensionalen Ausgestaltung deutlich: An der Bodenseite des Leistungshalbleitermoduls 1 sind die als Einbaustecker 126 ausgebildeten elektrischen Steckverbinder für die Steuerung des Leistungshalbleitermoduls 1 sowie der modulseitige Kühlflüssigkeits-Einlass 131 und der modulseitige Kühlflüssigkeits-Auslass 133 angeordnet und an den beiden Stirnseiten einander gegenüberliegend die externen Gleichspannungsanschlüsse 123 sowie die externen Wechselspannungsanschlüsse 127. Auf der externen Kühleinrichtung 2 sind die Leistungshalbleitermodule 1 mit einander zugewandten Seitenflächen dicht an dicht angeordnet (siehe Fig. 3 und Fig. 5a, 5b).

Bei dem in Fig. 4 und 5 dargestellten Ausführungsbeispiel sind sowohl die externen Gleichspannungsanschlüsse 123 als auch die externen Wechselspannungsanschlüsse 127 als Gewindesacklöcher ausgebildet, in die Befestigungsschrauben zur Herstellung von elektrischen Schraubverbindungen eindrehbar sind.

### Bezugszeichenliste

- 1: Leistungshalbleitermodul 1
- 11: Gehäuse
- 12: leistungselektronisches Subsystem
- 121: Wechselspannungsanschluss
- 122: interner Gleichspannungsanschluss
- 122k: Kondensator
- 122v: interne Gleichspannungsverschienung
- 123: externer Gleichspannungsanschluss
- 124: Steuerungsanschluss
- 125: Steuerungsplatine
- 126: Einbaustecker
- 127: externer Wechselspannungsanschluss
- 13: Kühleinrichtung
- 131: Kühlflüssigkeits-Einlass
- 132: Kühlkammer
- 133: Kühlflüssigkeits-Auslass
- 134: Kühlblöcke
- 2: externe Kühleinrichtung
- 21: erster Durchtrittskanal
- 22: zweiter Durchtrittskanal
- 23: Leitungskanal
- 3: Steuerungsmodul
- 31: Bus-Leiterplatte
- 311: Buchse
- 4: leistungselektronische Anordnung

## Patentansprüche

1. Flüssigkeitsgekühltes Leistungshalbleitermodul (1),
**dadurch gekennzeichnet,**
**dass** das Leistungshalbleitermodul (1) ein elektrisch isolierendes Gehäuse (11) aufweist, in dem eine Kühleinrichtung (13) mit einem Kühlflüssigkeits-Einlass (131) und einem Kühlflüssigkeits-Auslass (133) für eine Kühlflüssigkeit sowie leistungselektronische Subsysteme (12) angeordnet sind, wobei die Kühleinrichtung (13) Kühlkammern (132) aufweist, in denen die leistungselektronischen Subsysteme (12) mit der Kühlflüssigkeit in thermischem Kontakt stehen.

2. Leistungshalbleitermodul nach Anspruch 1,
**dadurch gekennzeichnet,**
**dass** die Kühleinrichtung (13) aus einem elektrisch isolierenden Material ausgebildet ist.

3. Leistungshalbleitermodul nach Anspruch 1,
**dadurch gekennzeichnet,**
**dass** die Kühleinrichtung (13) aus Metall oder aus einer Metalllegierung ausgebildet ist.

4. Leistungshalbleitermodul nach einem der vorangehenden Ansprüche,
**dadurch gekennzeichnet,**
**dass** Steuerungsanschlüsse (124) der leistungselektronischen Subsysteme (12) als Kontaktfedern ausgebildet sind, die an Kontakten einer Steuerungsplatine (125) unter Druck anliegen.

5. Leistungshalbleitermodul nach einem der vorangehenden Ansprüche,
**dadurch gekennzeichnet,**
**dass** in dem Gehäuse (11) weiter Kondensatoren (122k) angeordnet sind, die mit internen Gleichspannungsanschlüssen (122) elektrisch verbunden sind.

6. Leistungshalbleitermodul nach Anspruch 5,
**dadurch gekennzeichnet,**
**dass** die Kondensatoren (122k) mit der Kühleinrichtung (13) in thermischem Kontakt stehen.

7. Leistungshalbleitermodul nach Anspruch 5 oder 6,
**dadurch gekennzeichnet,**
**dass** eine interne Gleichspannungsverschienung (122v) die internen Gleichspannungsanschlüsse (122) untereinander sowie mit den Kondensatoren (122k) und mit externen Gleichspannungsanschlüssen (123) verbindet.

8. Leistungselektronische Anordnung (4), umfassend mehrere Leistungshalbleitermodule (1) nach einem der Ansprüche 1 bis 7 und eine externe Kühleinrichtung (2), auf der die Leistungshalbleitermodule (1) nebeneinander angeordnet sind und die einen ersten Durchtrittskanal (21) und einen zweiten Durchtrittskanal (22) für eine Kühlflüssigkeit aufweist, wobei die modulseitigen Kühlflüssigkeits-Einlässe (131) mit dem ersten Durchtrittskanal (21) und die modulseitigen Kühlflüssigkeits-Auslässe (133) mit dem zweiten Durchtrittskanal (22) flüssigkeitsdicht verbunden sind.

9. Leistungselektronische Anordnung nach Anspruch 8,
**dadurch gekennzeichnet,**
**dass** die Leistungshalbleitermodule (1) im Kühlmittelkreislauf parallel geschaltet sind.

10. Leistungselektronische Anordnung nach Anspruch 8 oder 9,
**dadurch gekennzeichnet,**
**dass** die leistungselektronische Anordnung (4) weiter ein Steuerungsmodul (3) umfasst.

11. Leistungselektronische Anordnung nach Anspruch 8 oder 9,
**dadurch gekennzeichnet,**
**dass** die externe Kühleinrichtung (2) einen Leitungskanal (23) aufweist, in dem eine Bus-Leiterplatte (31) angeordnet ist, die Steckverbinder (311) aufweist, die mit Steuerungs-Steckverbindern (126) der Leistungshalbleitermodule (1) und mit Steuerungs-Steckverbindern des Steuerungsmoduls (3) verbindbar sind.

12. Leistungselektronische Anordnung nach Anspruch 11,
**dadurch gekennzeichnet,**
**dass** die Leistungshalbleitermodule (1) nach dem Aufsetzen auf die externe Kühleinrichtung (2) über die Steckverbinder (126, 311) steuerungsseitig untereinander und mit dem Steuerungsmodul (3) verbunden sind.
